Europäisches Patentamt

European Patent Office

Office européen des brevets

(11) Publication number: **0 198 698 B1**

(12) **EUROPEAN PATENT SPECIFICATION**

(45) Date of publication of patent specification: **23.10.91**　(51) Int. Cl.⁵: **H01P  3/08**, H01P 5/02

(21) Application number: **86302753.8**

(22) Date of filing: **14.04.86**

(54) **Integrated circuit device having strip line structure therein.**

(30) Priority: **13.04.85 JP 77550/85**

(43) Date of publication of application:
**22.10.86 Bulletin 86/43**

(45) Publication of the grant of the patent:
**23.10.91 Bulletin 91/43**

(84) Designated Contracting States:
**AT DE FR GB IT SE**

(56) References cited:
**EP-A- 0 198 621**
**GB-A- 2 007 911**
**GB-A- 2 181 300**
**US-A- 4 047 132**

**IEE PROCEEDINGS, vol. 128, part H, no. 1, February 1981, pages 26-33; P.S. HALL et al.: "Design of microstrip antenna feeds. Part 2: Design and performance limitations of triplate corporate feeds"**

**PATENT ABSTRACTS OF JAPAN, vol. 8, no. 285 (E-287)[1722], 26th December 1984; & JP-A-59 152 649 (NIPPON DENKI K.K.) 31-08-1984**

(73) Proprietor: **FUJITSU LIMITED**
**1015, Kamikodanaka Nakahara-ku**
**Kawasaki-shi Kanagawa 211(JP)**

(72) Inventor: **Miyauchi, Akira**
**Mezon Hisasue 303 473-4, Hisasue**
**Takatsu-ku Kawasaki-shi Kanagawa 213(JP)**
Inventor: **Nishimoto, Hiroshi**
**c/o Suzuki, 15-3 Takaban 1-chome**
**Meguro-ku Tokyo 152(JP)**
Inventor: **Okiyama, Tadashi Fujimiso 1261**
**Kamikodanaka Nakahara-ku**
**Kawasaki-shi Kanagawa 211(JP)**
Inventor: **Kitasagami, Hiroo**
**Shirahatadaijutaku 4-203**
**2-3-1, Shirahatadai Miyamae-ku**
**Kawasaki-shi Kanagawa 213(JP)**
Inventor: **Sugimoto, Masahiro**
**27-13, Shonantakatori 5-chome**
**Yokosuka-shi Kanagawa 237(JP)**
Inventor: **Tamada, Haruo**
**26-23-310, Hosen 2-chome Hodogaya-ku**
**Yokohama-shi Kanagawa 240(JP)**
Inventor: **Emori, Shinji**
**1345-51, Tajima**
**Urawa-shi Saitama 336(JP)**

(74) Representative: **Fane, Christopher Robin King et al**
**HASELTINE LAKE & CO. Hazlitt House 28 Southampton Buildings Chancery Lane London, WC2A 1AT(GB)**

## Description

The present invention relates to integrated circuit devices including microwave transmission lines for use, for example, in circuits required to operate at high speeds.

High speed semiconductor integrated circuit (IC) chips for use in optical or other data processing applications at rates of, for example, one giga-bit per second (1Gb/s) are commercially available. In such a device a plurality of circuit elements, such as transistors and resistors, are formed in a chip made of semiconductor material such as silicon (Si) or gallium-arsenide (GaAs), the semiconductor IC chip being hermetically sealed in a package, in the same way as for other semiconductor IC chips.

At the high frequencies concerned, the connection (lead) lines of nominally resistive material between circuit elements in the device must be regarded not only as resistive components but also as inductive components, lines having both low resistance and low inductance being required for high speed signal transfer lines. On the other hand, lines having high inductance are required for power supply lines and low speed signal transfer lines, to improve isolation between different power sources and between the circuit elements in the device. In high speed IC devices, impedance matching of the connection lines is also required: thus conventional line connection techniques used in well known ordinary semiconductor IC devices may be inapplicable. Accordingly, such a high-speed IC device is provided with a stacked layer structure comprising a plurality of vertically stacked composite layers, each composite layer consisting of an insulation layer on which a plurality of conductive strips are formed in a layer-form conductive pattern, and connection members embedded in the stacked layers in a direction perpendicular to the planes of the stacked layers. The IC chip in which the circuit elements are formed is mounted on the top of the stacked layers and hermetically sealed in a package. Connections between circuit elements in the IC device are made by means of the connection members and the conductive strips in the layer structure.

The above requirement for impedance matching should be also applied to external connection lines between the high speed IC device and other high speed IC devices or other high speed operation circuits. Accordingly, triplate strip lines or microstrip lines are used for such external connection lines. However, in the prior art, connections between triplate strip lines and microstrip lines can suffer from the disadvantage of poor impedance matching, as will be described alter with reference to a specific example. In particular, the above-mentioned poor impedance matching may cause unacceptable degradation of the performance of high speed IC devices at operating speeds of greater than one giga-bit per second.

According to the present invention, there is provided an integrated circuit device comprising a semiconductor chip, having a plurality of circuit elements, enclosed within hermetically sealed packaging means and connected to an external terminal of the device by means of a microstrip transmission line, within the said packaging means, connected in series with a triplate transmission line; characterised by a first insulating layer provided on one main surface thereof with a first layer-form pattern of conductive material, a second insulating layer having one main surface in contact with the said first pattern of conductive material and provided on its opposite main surface with a second layer-form pattern of conductive material, a third insulating layer having one main surface in contact with the said second pattern of conductive material and provided on its opposite main surface with a third layer-form pattern of conductive material, and a fourth insulating layer having one main surface in contact with the said third pattern of conductive material and provided on its opposite main surface with a fourth layer-form pattern of conductive material, each of the said first, second, third and fourth layer-form patterns consisting of at least one conductive strip; and further characterised in that the said microstrip transmission line is constituted by a strip portion of the said fourth pattern together with respective adjacent portions of the said fourth insulating layer and the said third pattern, one terminal of the said semiconductor chip being connected to the microstrip transmission line at one end of the said strip portion of the fourth pattern, the other end of that strip portion being connected by way of a conductor passing through the said third and fourth insulating layers to one end of a strip portion of the second pattern, the other end of which is connected to an external terminal of the device, the said triplate transmission line being constituted by the said strip portion of the said second pattern together with respective adjacent portions of the said third conductive layer and the said third insulating layer and the said second insulating layer and the said first conductive layer, and the width of the said strip portion of the said second pattern, measured parallel to the main surface of the said second insulating layer, being smaller than that of the said strip portion of the said fourth pattern, so that the characteristic impedance of the said triplate transmission line is substantially equal to that of the said microstrip transmission line.

Such a device has the worthwhile advantage that different portions of a common layer are used to provide respective parts of the microstrip and triplate transmission lines, thereby producing a device structure that is compact, efficient in its use of materials, and relatively easy to construct.

Reference will now be made, by way of example, to the accompanying drawings, in which:

Figure 1a shows a sectional view of a part of a prior integrated circuit (IC) device taken along the line X-X' in Figure 1b;

Figure 1b shows a plan view of the IC device taken along the line H-H' in Figure 1a;

Figure 2 shows a sectional view of an IC device embodying the present invention;

Figure 3a shows a plan view of a part of the IC device shown in Figure 2, indicated by a reference $A_1$ and taken along the line H-H' in Figure 2;

Figure 3b shows a sectional view of the IC device taken along the line Y-Y' in Figure 3a;

Figure 4 shows a perspective view of a part of the IC device shown in Figure 2 and indicated by reference B.

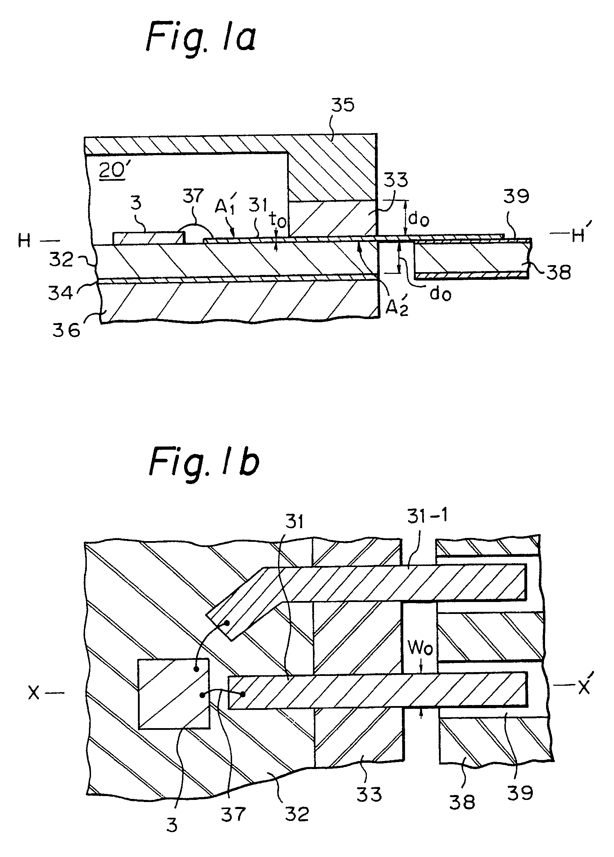

Referring to Figures 1a and 1b, an IC device includes a semiconductor IC chip 3 having a semiconductor substrate of Si or GaAs on which a plurality of transistors and other circuit elements are formed, mounted on an insulation layer 32 of ceramic or the like. The IC device also includes a stacked layer structure consisting of a conductive wire strip 31 formed on the insulation layer 32 and further consisting of a metal film 34 placed beneath the insulation layer 32 and mounted on another insulation layer 36. The IC device further includes a package including an insulator 33 and a metal cap 35. A hermetically sealed cavity 20', wherein the IC chip 3 is located, is defined by the package and the stacked layer structure. The conductive wire strip 31 is connected to a terminal of the IC chip 3 by soldering 37. The conductive wire strip 31 extends outside the IC device through a hermetic seal portion and is soldered to a connection wire 39 on a substrate 38 positioned outside and adjacent to the IC device. Accordingly, the conductive wire strip 31 functions as an external connection wire. Another conductive wire strip 31-1 (Figure 1b) can also be provided.

In Figure 1a, the conductive wire strip 31 may have, at a portion indicated by reference $A_1'$, a microstrip line structure, because the metal film 34 is provided beneath the conductive wire strip 31 and separated therefrom by the insulation layer 32, and the cavity 20' is provided above the conductive wire strip 31. In addition, another portion of the conductive wire strip 31, indicated by reference $A_2'$, may be a balanced-type strip line structure, i.e. a triplate strip line structure, because the conductive wire strip 31 is enclosed between the metal cap 35 and the metal film 34 by the insulator 33 and the insulator layer 32, both the insulator 33 and the insulating layer 32 having the same thickness $d_0$ and same dielectric constant $\epsilon$.

Note that the thickness $t_0$ and width $W_0$ of the conductive wire strip 31 are identical at portions indicated by references $A_1'$ and $A_1'$. For example, when the dielectric constant $\epsilon$ = 10, the insulation thickness $d_0$ = 330 $\mu$m, the conductive wire strip thickness $t_0$ = 15 $\mu$m, and the conductive wire strip width $W_0$ = 300 $\mu$m, the characteristic impedance $Z_0$ at the portion indicated by reference $A_1'$ is 50$\Omega$, which is a desired characteristic impedance in the example. However, a different characteristic impedance $Z_0'$ of approximately 33$\Omega$ will be obtained at the portion indicated by reference $A_2'$ due to the dielectric effect of the insulator 33. As a result, a mismatching between the respective characteristic impedances of the microstrip and the triplate line structures occurs and brings about a reflection loss.

Preferred embodiments of the present invention will now be described.

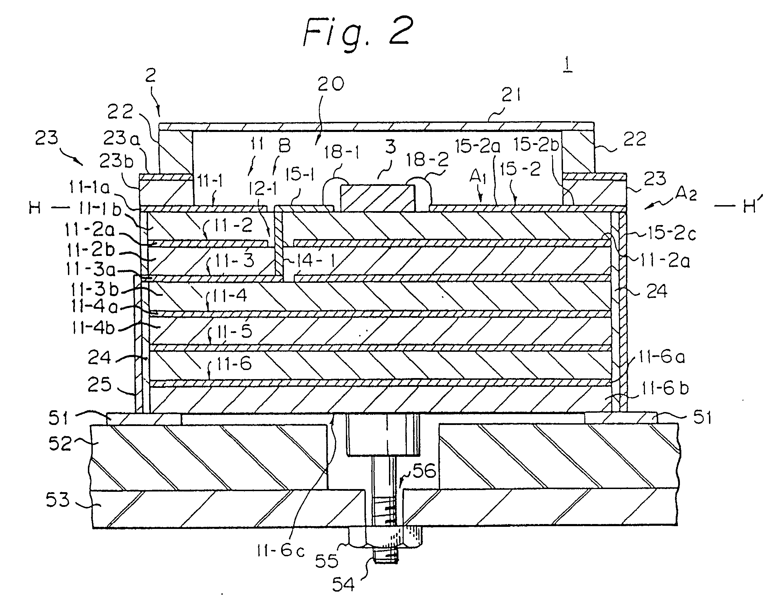

Referring to Figure 2, an IC device 1 embodying the present invention includes a package 2, the package 2 consisting of a cap 21 formed of an insulation material, an upper shield 22 formed of an insulation material, a seal layer 23, and a side wall 24 formed of an insulation material. The IC device 1 further comprises an IC chip 3, including a plurality of circuit elements formed on a semiconductor substrate of Si or GaAs, and a stacked layer unit 11. The IC chip 3 is mounted on the top of the stacked layer unit 11 and is located in a hermetically sealed cavity 20 defined by the package 2 and the stacked layer unit 11. The above-mentioned insulation material is typically a dielectric material.

The IC device 1 is mounted on a printed circuit board 52 through conductive leads 51 and is secured to a plate 53 through a stud 54 having one end fixed to a bottom surface 11-6C of the stacked layer unit 11, the shaft of the stud 54 passing through a hole 56 in the printed circuit board 52 and the plate 53, and the other end of the stud 54 being fastened to the plate 53 by a nut 55.

The stacked layer unit 11 includes six stacked layers 11-1 to 11-6. Each of the stacked layers 11-1 to 11-6 includes an insulation layer or a dielectric layer, as shown by the layer 11-1b for the upper layer 11-1, and a layer-form pattern of conductive material, as shown by the pattern 11-1a for the upper layer 11-1, which pattern consists of at least one conductive layer strip. The insulation layers 11-1b, etc., are formed of a sintered ceramic and have a thickness of approximately 300 um and a dielectric constant of 10.

Two conductive wire strips 15-1 and 15-2 are also provided in the pattern 11-1a on the insulation layer 11-1b adjacent to the IC chip 3.

The conductive layer strips of the second layer 11-2 are used for ground lines or power supply lines. The conductive layer strips of the fourth and sixth layers 11-4 and 11-6 are also used for ground lines or power supply lines. Conductive layer strips of the third layer 11-3 are used for high speed signal lines. The conductive layer strips of the fifth layer 11-5 are used for low speed signal lines.

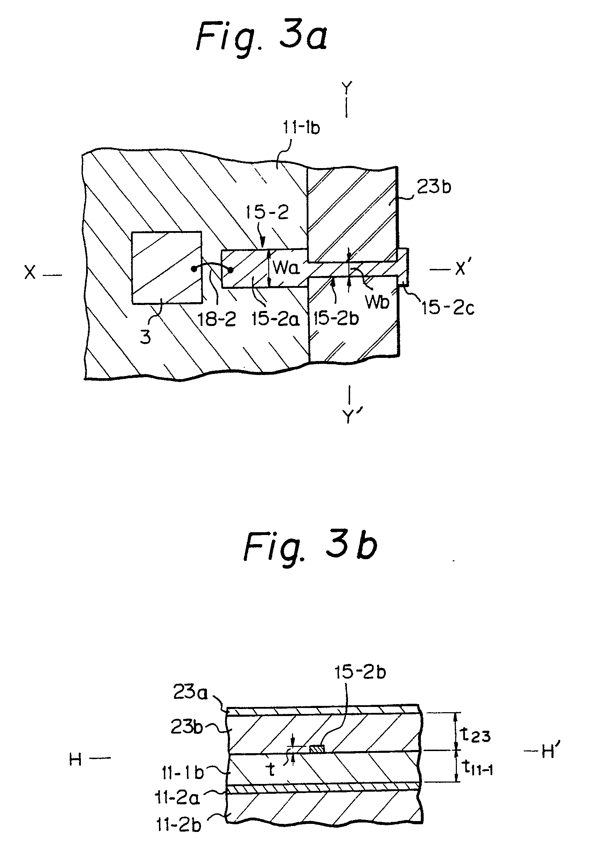

Figure 3a is a plan view of a part of the IC device denoted by references $A_1'$ and $A_2'$ in Figure 2 and taken along the line H-H' in Figure 2. Figure 3b is a sectional view of the IC device, taken along the line Y-Y' in Figure 3a. Figures 3a and 3b correspond respectively to Figures 1b and 1a discussed above.

In Figures 2, 3a and 3b, the conductive wire strip 15-2 varies in width along its length and includes a relatively wide portion 15-2a, a relatively narrow portion 15-2b, and a further relatively wide portion 15-2c. The width $W_a$ of the wider portions 15-2a and 15-2c is 300 um and the width $W_b$ of the narrower portion 15-2b is 100 um. The thickness t of the conductive wire strip 15-2b is a uniform 15 um throughout the portions 15-2a to 15-2c. The length of the narrower portion 15-2b is identical to that of the seal layer 23. The conductive wire strip 15-2 functions as an external connection wire. One end of the wider portion 15-2a of the conductive wire strip 15-2 inside the IC device is connected to a terminal of the IC chip 3 through a wire 18-2 and the other end of the conductive wire strip 15-2 (i.e. the further wide portion 15-2c which lies outside the IC device and extends down the side wall 24) may be connected to other circuits in other IC devices. The further wide portion 15-2c may be formed as a co-planar strip line.

The structure associated with the wide portion 15-2a of the conductive wire 15-2 and denoted by reference $A_1$ in Figure 2 is similar to that shown in Figure 1a and thus constitutes a microstrip line structure, because the conductive layer 11-2a formed on the insulation layer 11-2b of the second layer 11-2 is provided beneath the wide portion 15-2a and the cavity 20 is provided above the wide portion 15-2a. The insulation layer 11-2b between the wide portion 15-2a of the conductive wire strip 15-2 and the conductive layer 11-2a is (like the layer 32 of Figure 1a) also formed of a sintered ceramic and has a thickness of approximately 330 $\mu$m and a dielectric constant of 10. As a result, the characteristic impedance of the microstrip line structure is 50$\Omega$. ·

In addition, another structure, associated with the narrow portion 15-2b of the conductive wire strip 15-2 and denoted by reference $A_2$, includes the insulation layer 11-1b, the conductive layer 11-2a and the seal layer 23, which consists of an insulation layer 23b (formed of a sintered ceramic and having a thickness $t_{23}$ of approximately 330 $\mu$m, identical to the thickness $t_{11-1}$ of the insulation layer 11-1b, and a dielectric constant of 10) and a conductive layer 23a formed on the insulation layer 23b. The narrow portion 15-2b has a width Wb of 100 $\mu$m, which is narrower than that of the wide portion 15-2a. Capacitors are formed in the insulation layer 23b and the insulation layer 11-1b, so that the portion concerned has a triplate strip line structure. By providing the above-mentioned capacitors above and below the portion 15-2b, the width $W_b$ of the narrow width portion 15-2b may be reduced. In this triplate strip line structure, the width $W_b$ of the narrow width portion 15-2b ($W_b$ = 100 $\mu$m) is chosen so that any adverse effects due to the dielectric constant of the insulation layer 23b may be cancelled. As a result, the characteristic impedance of the triplate strip line structure is 50$\Omega$, identical to that of the microstrip line structure described above.

Accordingly the conductive wire strip 15-2 functions as an external connection wire which has impedance matching along its entire length, with the result that losses such as reflection loss do not occur.

In the above embodiment, the principal requirement is to make the characteristic impedance of the triplate strip line structure, which is altered by the presence of the insulation layer 23b, equal to that of the microstrip line structure. More specifically, the capacitance of the narrow width portion 15-2b is set to a predetermined value so that impedance matching is achieved between the two structures.

The characteristic impedance can be arbitrary, and could, for example, be 75$\Omega$.

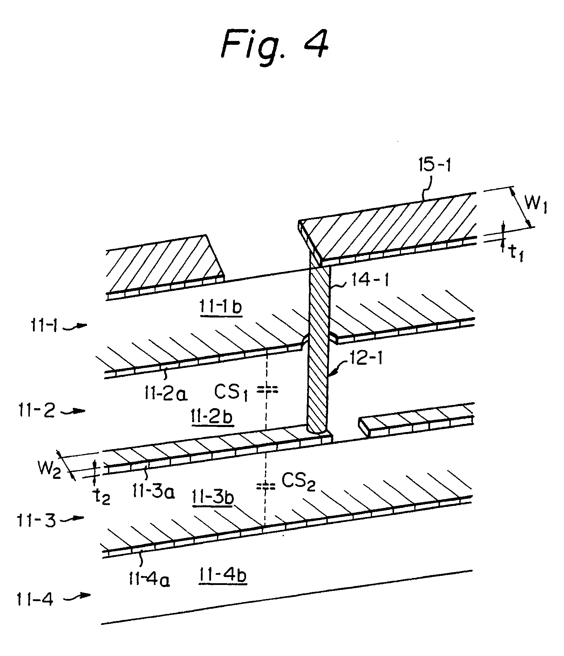

Figure 4 is a perspective view of the IC device at the portion indicated by reference B in Figure 2. In Figures 2 and 4, the conductive wire strip 15-1, formed on the insulation layer 11-1b, is electrically connected to the conductive strip 11-3a, formed on the insulation layer 11-3b, by means of a viahole 14-1 consisting of electrically conductive material inserted into a throughhole 12-1 formed in the insulation layers 11-1b and 11-2b, in a direction perpendicular to the planes of those layers.

A microstrip line structure is constituted by the conductive layer 11-2a, the insulation layer 11-1b, the conductive wire strip 15-1, and the cavity 20 above the conductive wire strip 15-1 in the same way as set forth with reference to Figures 3a and 3b. The thickness $t_1$ of the conductive wire strip 15-1 is 15 $\mu$m and the width $W_1$ is 300 $\mu$m, these dimensions being equal to those of the wide portion 15-2a of the conductive wire strip 15-2. The thickness and material of the insulation layer 11-1b are as mentioned above. Accordingly, the characteristic impedance of the structure associated with the conductive wire strip 15-1 is 50Ω.

A triplate strip line structure is also constituted by the conductive layer 11-4a formed on the insulation layer 11-4b, the insulation layer 11-3b, the conductive strip 11-3a, the insulation layer 11-2b, and the conductive layer 11-2a in the same way as set forth with reference to Figures 3a and 3b. Capacitors $CS_1$ and $CS_2$ are formed in the insulation layers 11-2b and 11-3b. The thickness $t_2$ of the conductive strip 11-3a is identical to the thickness $t_1$ of the conductive wire strip 15-2, and the width $W_2$ is 100 $\mu$m, which is identical to the width $W_b$ in Figure 3a. By providing the capacitors $CS_1$ and $CS_2$ above and below the conductive strip 11-3a, the width $W_2$ may be reduced as described previously. The thickness and material of the insulation layer 11-3b are identical to those of the insulation layer 11-2b. The width $W_2$ is smaller than the width $W_1$, and accordingly the triplate strip line structure has a characteristic impedance of 50Ω identical to that of the microstrip line structure of the conductive wire strip 15-1, despite the effect of the dielectric constant of the insulation layer 11-2b, described above with reference to Figures 3a and 3b.

In this embodiment, impedance matching between the microstrip line structure and the triplate strip line structure is achieved in the external connection line constituted by the conductive wire strip 15-1, the viahole 14-1 and the conductive layer 11-3a, with the result that losses such as reflection loss do not occur.

Furthermore, because in this embodiment the conductive layer 11-2a provides both the upper conductive layer of the triplate strip line structure and the conductive base layer of the microstrip line structure, the IC device is compact, efficient in its use of materials, and relatively easy to construct.

One end of this external connection wire is connected to a terminal of the IC chip 3 inside the IC device, and the other end outside the IC device is connected to a co-planar strip line 25 mounted on the surface of the side wall 24 as shown in Figure 2.

Many widely different embodiments of the present invention may be constructed without departing from the spirit and scope of the present invention. It should be understood that the present invention is not limited to the specific embodiments described in this specification, except as defined in the appended claims.

## Claims

1. An integrated circuit device comprising a semiconductor chip (3), having a plurality of circuit elements, enclosed within hermetically sealed packaging means (21 to 24) and connected to an external terminal (25) of the device by means of a microstrip transmission line, within the said packaging means, connected in series with a triplate transmission line; characterised by a first insulating layer (11-4b) provided on one main surface thereof with a first layer-form pattern (11-4a) of conductive material, a second insulating layer (11-3b) having one main surface in contact with the said first pattern of conductive material and provided on its opposite main surface with a second layer-form pattern (11-3a) of conductive material, a third insulating layer (11-2b) having one main surface in contact with the said second pattern of conductive material and provided on its opposite main surface with a third layer-form pattern (11-2a) of conductive material, and a fourth insulating layer (11-1b) having one main surface in contact with the said third pattern of conductive material and provided on its opposite main surface with a fourth layer-form pattern (11-1a) of conductive material, each of the said first, second, third and fourth layer-form patterns (11-4a, 11-3a, 11-2a, 11-1a) consisting of at least one conductive strip; and further characterised in that the said microstrip transmission line is constituted by a strip portion (15-1) of the said fourth pattern (11-1a) together with respective adjacent portions of the said fourth insulating layer (11-1b) and the said third pattern (11-2a), one terminal of the said semiconductor chip being connected to the microstrip transmission line at one end of the said strip portion (15-1) of the fourth pattern, the other end of that strip portion (15-1) being connected by way of a conductor (14-1) passing through the said third and fourth insulating layers to one end of a strip portion of the second pattern (11-3a), the other end of which is connected to an external terminal (25) of the device, the said triplate transmission line being constituted by the said strip portion of the said second pattern (11-3a) together with respective adjacent portions of the said third conductive layer (11-2a) and the said third insulating layer (11-2b) and the said second insulating layer (11-3b) and the said first conductive layer (11-4a), and the width of the said strip portion of the said second pattern (11-3a), measured parallel to the main surface of the said second insulating layer (11-3b), being smaller than that of the said strip portion (15-1) of the said fourth pattern (11-1a), so that the characteristic impedance of the said triplate transmission line is substantially equal to that of the said microstrip transmission line.

2. A device as claimed in claim 1, wherein the said semiconductor chip (3) is connected to a further external terminal (15-2c) of the device by means of a further microstrip transmission line, within the said packaging means, connected in series with a further triplate transmission line that leads to the said further external terminal (15-2c).

3. A device as claimed in claim 2, wherein the said packaging means includes a further layer-form insulating portion (23b) having one main surface in contact with the said fourth layer-form pattern of conductive material (11-1a) and provided on its opposite main surface with a further layer-form conductive portion (23a), and wherein the said further microstrip transmission line is constituted by a further strip portion (15-2a) of the said fourth pattern (11-1a) together with respective adjacent portions of the said fourth insulating layer (11-1b) and the said third pattern (11-2a), a second terminal of the said semiconductor chip being connected to the said further microstrip transmission line at one end of the said further strip portion (15-2a) of the fourth pattern, the other end of that further strip portion being directly connected to one end of an additional strip portion (15-2b) of the said fourth pattern (11-1a), which additional strip portion constitutes the central conductor of the said further triplate transmission line and is connected at its other end to the said further external terminal (15-2c) of the device, the other conductors of the said further triplate transmission line being provided respectively by the said further layer-form conductive portion (23a) and a portion of the said third pattern (11-2a), the width of the said additional strip portion (15-2b) as measured parallel to the main surface of the said fourth insulating layer (11-1b) being smaller than that of the said further strip portion (15-2a) of the said further microstrip transmission line so that the characteristic impedance of the said further triplate transmission line is substantially equal to that of the said further microstrip transmission line.

4. A device as claimed in claim 1, 2 or 3, wherein the said semiconductor chip (3) is mounted on the said opposite main surface of the said fourth insulating layer (11-1b).

## Revendications

1. Dispositif de circuit intégré comprenant une puce à semiconducteur (3) qui a une pluralité d'éléments de circuit, qui est enfermée à l'intérieur d'un moyen de boîtier hermétiquement scellé (21 à 24) et qui est connectée à une borne externe (25) au dispositif au moyen d'une ligne de transmission microbande située à l'intérieur dudit moyen de boîtier, cetteligne étant connectée en série à une ligne de transmission triplaque ; caractérisé par une première couche isolante (11-4b) munie, sur une de ses surface principales, d'une première conformation en forme de couche (11-4a) d'un matériau conducteur, une seconde couche isolante (11-3b) qui a une surface principale en contact avec ladite première conformation en matériau conducteur et qui est munie, sur sa surface principale opposée, d'une seconde conformation en forme de couche (11-3a) en un matériau conducteur, une troisième couche isolante (11-2b) qui a une surface principale en contact avec ladite seconde conformation en matériau conducteur et qui est munie, sur sa surface principale opposée, d'une troisième conformation en forme de couche (11-2a) en un matériau conducteur, et une quatrième couche isolante (11-1b) qui a une surface principale en contact avec ladite troisième conformation en matériau conducteur et qui est munie, sur sa surface principale opposée, d'une quatrième conformation en forme de couche (11-1a) en un matériau conducteur, chacune des première, seconde troisième et quatrième conformations en forme de couche (11-4a, 11-3a, 11-2a, 11-1a) étant constituée par au moins une bande conductrice ; et caractérisé en outre en ce que ladite ligne de transmission microbande est constituée par une partie de bande (15-1) de ladite quatrième conformation (11-1a) associée à des parties adjacentes respectives de ladite quatrième couche isolante (11-1b) et de ladite troisième conformation (11-2a), une borne de ladite puce semiconductrice étant connectée à la ligne de transmission microbande au niveau d'une extrémité de ladite partie de bande (15-1) de la quatrième conformation, l'autre extrémité de cette partie de bande (15-1) étant connectée au moyen d'un conducteur (14-1) qui traverse lesdites troisième et quatrième couches isolantes à une extrémité d'une partie de bande de la seconde conformation (11-3a) dont l'autre extrémité est connectée à une borne externe (25) du dispositif, ladite ligne de transmission triplaque étant constituée par ladite partie bande de ladite seconde conformation (11-3a) associée à des parties adjacentes respectives de ladite troisième couche conductrice (11-2a) et ladite troisième couche isolante (11-2b) et de ladite seconde couche isolante (11-3b) et ladite première couche conductrice (11-4a), et la largeur de ladite partie de bande de ladite seconde conformation (11-3a), lorsqu'on la mesure parallèlement à la surface principale de ladite seconde couche iso-lante (11-3b), étant inférieure à celle de ladite par-tie de bande (15-1) de ladite quatrième conformation (11-1a) de telle sorte que l'impédance caractéristique de ladite ligne de transmission triplaque soit sensiblement égale à celle de ladite ligne de transmission microbande.

2. Dispositif selon la revendication 1, dans lequel ladite puce semiconductrice (3) est connectée à une autre borne externe (15-2c) du dispositif au moyen d'une autre ligne de transmission microbande, à l'intérieur dudit moyen de boîtier, cette ligne étant connectée en série avec une autre ligne de transmission triplaque qui conduit à ladite autre borne externe (15-2c).

3. Dispositif selon la revendication 2, dans lequel ledit moyen de boîtier inclut une autre partie d'isolation en forme de couche (23b) qui a une surface principale en contact avec ladite quatrième conformation en forme de couche en matériau conducteur (11-1a) et qui est pourvue sur sa surface principale opposée d'une autre partie conductrice en forme de couche (23a), et dans lequel ladite autre ligne de transmission microbande est constituée par une autre partie de bande (15-2a) de ladite quatrième conformation (11-1a) associée à des parties adjacentes respectives de ladite quatrième couche isolante (11-1b) et de ladite troisième conformation (11-2a), une seconde borne de ladite puce semiconductrice étant connectée à ladite autre ligne de transmission microbande au niveau d'une extrémité de ladite autre partie de bande (15-2a) de la quatrième conformation, l'autre extrémité de cette autre partie de bande étant directement connectée à une extrémité d'une partie de bande supplémentaire (15-2b) de ladite quatrième conformation (11-1a), cette partie de bande supplémentaire constituant le conducteur central de ladite autre ligne de transmission triplaque et étant connectée au niveau de son autre extrémité à ladite autre borne externe (15-2c) du dispositif, les autres conducteurs de ladite autre ligne de transmission triplaque étant constitués respectivement par ladite autre partie conductrice en forme de couche (23a) et par une partie de ladite troisième conformation (11-2a), la largeur de ladite partie de bande supplémentaire (15-2b), lorsqu'on la mesure parallèlement à la surface principale de ladite quatrième couche isolante (11-1b), étant inférieure à celle de ladite autre partie de bande (15-2a) de ladite autre ligne de transmission microbande de telle sorte que l'impédance caractéristique de ladite autre ligne de transmission triplaque soit sensiblement égale à celle de ladite autre ligne de transmission microbande.

4. Dispositif selon la revendication 1, 2 ou 3, dans lequel ladite puce semiconductrice (3) est montée sur ladite surface principale opposée de ladite quatrième couche isolante (11-1b).

## Patentansprüche

1. Integrierte Schaltungsvorrichtung mit einem Halbleiterchip (3), mit einer Vielzahl von Schaltungselementen, das in einer hermetisch versiegelten Packungseinrichtung (21-24) eingeschlossen und mit einem externen Anschluß (25) der Vorrichtung mittels einer Mikrostreifen-Transmissionsleitung, innerhalb der genannten Packungseinrichtung, verbunden ist, die in Reihe mit einer Drei-Platten-Transmissionsleitung verbunden ist; gekennzeichnet durch eine erste Isolationsschicht (11-4b), die auf ihrer einen Hauptoberfläche mit einem schichtförmigem Muster (11-4a) aus leitendem Material versehen ist, eine zweite isolierende Schicht (11-3b), die eine Hauptoberfläche hat, welche mit dem genannten ersten Muster aus leitendem Material in Kontakt ist, und auf ihrer gegenüber liegenden Hauptoberfläche mit einem zweiten schichtförmigen Muster (11-3a) aus leitendem Material versehen ist, eine dritte isolierende Schicht (11-2b), die eine Hauptoberfläche hat, welche mit dem genannten zweiten Muster aus leitendem Material in Kontakt ist, und auf ihrer gegenüberliegenden Hauptoberfläche mit einem dritten schichtförmigen Muster (11-2a) aus leitendem Material versehen ist, und eine vierte isolierende Schicht (11-1b), die eine Hauptoberfläche hat, welche mit dem genannten dritten Muster aus leitendem Material in Kontakt ist, und auf ihrer gegenüberliegenden Hauptobefläche mit einem vierten schichtförmigen Muster (11-1a) aus leitendem Material versehen ist, wobei jedes der genannten ersten, zweiten, dritten und vierten schichtförmigen Muster (11-4a, 11-3a, 11-2a, 11-1a) aus wenigstens einem leitenden Streifen besteht; und ferner dadurch gekennzeichnet, daß die genannte Mikrostreifen-Transmissionsleitung von einem Streifenanschnitt (15-1) des genannten vierten Musters (11-1a) zusammen mit entsprechenden angrenzenden Abschnitten der genannten vierten isolierenden Schicht (11-1b) und des genannten dritten Musters (11-2a) gebildet wird, wobei ein Anschluß des genannten Halbleiterchip mit der Mikrostreifen-Transmissionsleitung an einem Ende des genannten Streifenabschnitts (15-1) des vierten Musters verbunden ist, das andere Ende des Streifenabschnittes (15-1) mittels eines Leiters (14-1), der durch die genannten dritten und vierten isolierenden Schichten verläuft, mit einem Ende eines Streifenabschnitts des zweiten Musters (11-3a) verbunden ist, dessen anderes Ende mit einem externen Anschluß (25) der Vorrichtung verbunden ist, wobei die genannte Drei-Platten-Transmissionsleitung von dem genannten Streifenabschnitt des genannten zweiten Musters (11-3a) zusammen mit entsprechenden benachbarten Anschnitten der genannten dritten leitenden Schicht (11-2a) und der genannten dritten isolierenden Schicht (11-2b) und der genannten zweiten isolierenden Schicht (11-3b) und der genannten ersten leitenden Schicht (11-4a) gebildet ist, und die Breite des genannten Streifenabschnitts des genannten zweiten Musters (11-3a), gemessen parallel zu der Hauptoberfläche der genannten zweiten isolierenden Schicht (11-3b), kleiner als jene des genannten Streifenabschnitts (15-1) des genannten vierten Musters (11-1a) ist, so daß der Wellenwiderstand der genannten Drei-Platten-Transmissionsleitung im wesentlichen gleich jenem der genannten Mikrostreifen-Transmissionsleitung ist.

2. Vorrichtung nach Anspruch 1, bei der der genannte Halbleiterchip (3) mit einem weiteren externen Anschluß (15-2c) der Vorrichtung mittels einer weiteren Mikrostreifen-Transmissionsleitung, innerhalb der genannten Pakkungseinrichtung, verbunden ist, die in Reihe mit einer weiteren Drei-Platten-Transmissionsleitung verbunden ist, welche zu den genannten weiteren externen Anschluß (15-2c) führt.

3. Vorrichtung nach Anspruch 2, bei der die genannte Packungseinrichtung einen weiteren schichtförmigen, isolierenden Abschnitt (23b) aufweist, der eine Hauptoberfläche in Berührung mit dem genannten vierten schichtförmigen Muster des leitenden Materials (11-1a) hat und auf seiner gegenüberliegende Hauptoberfläche mit einem weiteren schichtförmigen, leitenden Abschnitt (23a) versehen ist, und bei der die genannte weitere Mikrostreifen-Transmissionsleitung durch einen weiteren Streifenabschnitt (15-2a) des genannten vierten Musters (11-1a) gebildet ist, zusammen mit entsprechenden benachbarten Abschnitten der genannten vierten isolierenden Schicht (11-1b) und des genannten dritten Musters (11-2a), wobei ein zweiter Anschluß des genannten Halbleiterchips mit der genannten weiteren Mikrostreifen-Transmissionsleitung an einem Ende des genannten weiteren Streifenabschnitts (15-2a) des vierten Muster verbunden ist, und das andere Ende des weiteren Streifenabschnitts direkt mit einem Ende eines zusätzlichen Streifenabschnitts (15-2b) des genannten vierten Musters (11-1a) verbunden ist, welcher zusätzliche Streifenabschnitt den zentralen Leiter der genannten weiteren Drei-Platten-Transmissionsleitung bildet und an seinem anderen Ende mit dem genannten weiteren externen Anschluß (15-2c) der Vorrichtung verbunden ist, wobei die anderen Leiter der genannten weiteren Drei-Platten-Transmissionsleitung jeweils durch den genannten weiteren schichtförmigen leitenden Abschnitt (23a) und einem Abschnitt des genannten dritten Musters (11-2a) gebildet ist, wobei die Breite des genannten zusätzlichen streifenförmigen Abschnitts (15-2b), gemessen parallel zu der Hauptoberfläche der genannten vierten isolierenden Schicht (11-1b), kleiner als jene des genannten weiteren streifenförmigen Abschnitts (15-2a) der genannten weiteren Mikrostreifen-Transmissionsleitung ist, so daß der Wellenwiderstand der genannten weiteren Drei-Platten-Platten-Transmissionsleitung im wesentlichen gleich jenem der genannten Mikrostreifen-Transmissionsleitung ist.

4. Vorrichtung nach Anspruch 1, 2 oder 3, bei der der genannten Halbleiterchip (3) auf der genannten gegenüberliegenden Hauptoberfläche der genannten vierten isolierenden Schicht (11-1b) angeordnet ist.

## Fig. Ia

## Fig. Ib

Fig. 2

# Fig. 3a

# Fig. 3b

# Fig. 4